(19)

Europäisches
Patentamt
European
Patent Office
Office européen
des brevets

(11) **EP 4 299 516 A1**

(12) **EUROPEAN PATENT APPLICATION**
published in accordance with Art. 153(4) EPC

(43) Date of publication:
**03.01.2024 Bulletin 2024/01**

(21) Application number: **22759556.8**

(22) Date of filing: **21.02.2022**

(51) International Patent Classification (IPC):
*C01B 33/06* (2006.01)  *H01B 3/12* (2006.01)
*C30B 29/38* (2006.01)  *H01L 35/30* (2006.01)
*H01L 35/32* (2006.01)

(52) Cooperative Patent Classification (CPC):
**C01B 33/06; C30B 29/38; H01B 3/12; H10N 10/13;
H10N 10/17**

(86) International application number:
**PCT/JP2022/006864**

(87) International publication number:
**WO 2022/181520 (01.09.2022 Gazette 2022/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 26.02.2021 JP 2021030791
20.12.2021 JP 2021206434

(71) Applicant: **Mitsubishi Materials Corporation
Tokyo 100-8117 (JP)**

(72) Inventors:
• **ADACHI Masaki
Naka-shi, Ibaraki 311-0102 (JP)**
• **FUJITA Toshiaki
Naka-shi, Ibaraki 311-0102 (JP)**

(74) Representative: **Hoffmann Eitle
Patent- und Rechtsanwälte PartmbB
Arabellastraße 30
81925 München (DE)**

(54) **NITRIDE INSULATOR MATERIAL, METHOD FOR MANUFACTURING SAME, HEAT FLOW
SWITCHING ELEMENT AND THERMOELECTRIC CONVERSION ELEMENT**

(57)     Provided are a nitride insulator material having low lattice thermal conductivity, a method for producing the same, a heat flow switching element, and a thermoelectric conversion element. The nitride insulator material of the present invention consists of a metal nitride represented by the general formula: M-Si-N-Te (where M represents at least one of Ta and Hf, and Te is an arbitrary element) and has a nanocrystalline structure. In addition, the heat flow switching element of the present invention includes: an N-type semiconductor layer 3; an insulator layer 4 laminated on the N-type semiconductor layer; and a P-type semiconductor layer 5 laminated on the insulator layer, wherein the insulator layer is made of the above-described nitride insulator material.

[FIG. 1]

EP 4 299 516 A1

**Description**

Technical Field

The present invention relates to a nitride insulator material having low lattice thermal conductivity, a method for producing the same, a heat flow switching element, and a thermoelectric conversion element.

Background Art

Conventionally, as a heat flow switch that actively changes thermal conductivity by a bias voltage, for example, Non-Patent Literature 1 has proposed a heat flow switching element that changes thermal conductivity by sandwiching a polyimide tape exhibiting electrical insulation between two semiconductor materials: $Ag_2S_{0.6}Se_{0.4}$ and applying an electric field.

Citation List

Non-Patent Literature 1: Takuya Matsunaga and four others, "Preparation of Heat flow switching Element Operating By Bias Voltage", the 15th Academic Lecture of Thermoelectrics Society of Japan, September 13, 2018

Summary of Invention

Technical Problem

The following problems still remain in the conventional technology described above.

In the technology described in Non-Patent Literature 1, electric charge capable of conducting heat can be produced at the interface between the semiconductor materials and the insulator material by application of a voltage and the resultant electric charge can transfer heat, whereby the thermal conductivity can be immediately changed, and thus relatively good thermal responsivity can be obtained. However, in order that the thermal conductivity derived from the material interface can be changed according to this external electric field (external voltage) so as to increase the rate of change in the thermal conductivity throughout the entire element, the thermal conductivity inherent to the material constituting the element needs to be decreased in a zero-bias state. Since the thermal conductivity is proportional to the square of the thermal effusivity, the thermal effusivity inherent to the material constituting the element needs to be decreased in a zero-bias state. The thermal conductivity inherent to the material in a zero-bias state is expressed as addition of the lattice thermal conductivity and the electronic thermal conductivity.

That is, Thermal conductivity = Lattice thermal conductivity + Electronic thermal conductivity.

The lattice thermal conduction is thermal conduction caused by vibration (phonon or lattice vibration) transmitting between crystal lattices, whereas the electronic thermal conduction is thermal conduction caused by conduction electron. In general, as the electric conductivity increases, the electronic thermal conductivity tends to increase. As to the electronic thermal conductivity of semiconductor, the electronic thermal conductivity inherent to the material in a zero-bias state needs to be adjusted to an appropriate value to the extent so as not to increase the total thermal conductivity in order to maintain the conductivity of semiconductor. Note that the insulator material exhibits no electronic thermal conduction. As to the lattice thermal conductivity, lower lattice thermal conductivity is more preferred. Since a material having low lattice thermal conductivity can decrease the thermal conductivity throughout the entire element in a zero-bias state, the rate of change in the thermal conductivity derived from the interface according to external electric field can be increased, thereby enhancing the heat flow switch performance of the entire element. Therefore, it is demanded to use a low-thermally-conductive (low-thermally-permeable) semiconductor material due to the low lattice thermal conductivity thereof together with an insulator material. It is also demanded to use a nitride material as one of the constituent materials for enhancing the heat resistance of a heat flow switching element.

It is also demanded to use an insulator material having low lattice thermal conductivity and high thermal insulation performance for a thermoelectric conversion element, because such a material can suppress heat radiated from the surface of the thermoelectric conversion portion and thereby sufficiently secure the temperature difference between the high-temperature side and the low-temperature side.

The present invention has been made in view of the aforementioned circumstances, and an object of the present invention is to provide a nitride insulator material having low lattice thermal conductivity, a method for producing the same, a heat flow switching element, and a thermoelectric conversion element.

Solution to Problem

The present invention adopts the following configuration in order to overcome the aforementioned problems. Specifically, a nitride insulator material according to a first aspect of the present invention consists of a metal nitride represented by the general formula: M-Si-N-Te (where M represents at least one of Ta and Hf, and Te is an arbitrary element) and has a nanocrystalline structure.

Since this nitride insulator material consists of a metal nitride represented by the general formula: M-Si-N-Te (where M represents at least one of Ta and Hf, and Te is an arbitrary element) and has a nanocrystalline structure, low thermal conduction indicating low thermal effusivity can be obtained due to the electrical insulation and the low lattice thermal conductivity. Therefore, the nitride insulator material of the present invention is suitable as an electric and thermal barrier material.

Note that the elements M (at least one of Ta and Hf) and Si among the constituent elements can allow the material to be nanocrystallized (to have a crystal size of 5 nm or less, including amorphous state) and the lattice thermal conductivity to be reduced, thereby decreasing the thermal effusivity. In addition, the content of the constituent element N can allow the material to have electrical insulation. Furthermore, the constituent element Te has an effect to further decrease the thermal effusivity.

Note that the expression "Te is an arbitrary element" means that the inclusion of tellurium (Te) is arbitrary. That is, Te may be included or not. In other words, the composition of the metal nitride can be M-Si-N or M-Si-N-Te (where M represents at least one of transition metal elements).

A nitride insulator material according to a second aspect of the present invention is characterized in that the nitride insulator material according to the first aspect has a thermal effusivity of less than 2000 $Ws^{0.5}/m^2K$.

Specifically, since this nitride insulator material has a thermal effusivity of less than 2000 $Ws^{0.5}/m^2K$, the thermal conductivity can be lower than that with $HfO_2$.

Note that the thermal effusivity is preferably 100 $Ws^{0.5}/m^2K$ or more.

A nitride insulator material according to a third aspect of the present invention is characterized in that the nitride insulator material according to the second aspect has a thermal effusivity of less than 1700 $Ws^{0.5}/m^2K$.

Specifically, since this nitride insulator material has a thermal effusivity of less than 1700 $Ws^{0.5}/m^2K$, the thermal conductivity can be lower than that with $HfO_2$ or SiN. Since this nitride insulator material exhibits lower thermal conductivity, i.e., higher heat insulation, it is more suitable for an insulator layer constituting a heat flow switching element and an insulator layer constituting a thermoelectric conversion element.

A nitride insulator material according to a fourth aspect of the present invention is characterized in that the nitride insulator material according to any one of the first to third aspects has an electrical resistivity of $10^8$ Qcm or more.

Specifically, since this nitride insulator material has an electrical resistivity of $10^8$ Qcm or more, electrical insulation that permits only electric current of less than 100 $\mu A/mm^2$ to flow can be obtained when applying 10V of voltage in the film thickness direction to a nitride insulator material having a film thickness of 100 nm.

A nitride insulator material according to a fifth aspect of the present invention is characterized in that the nitride insulator material according to any one of the first to fourth aspects is used as a low-thermally-conductive material.

Specifically, since this nitride insulator material can exhibit low thermal effusivity, it is suitable for a low-thermally-conductive insulator material used for a heat flow switching element, a thermoelectric conversion element, or the like.

A heat flow switching element according to a sixth aspect of the present invention comprises an N-type semiconductor layer, an insulator layer laminated on the N-type semiconductor layer, and a P-type semiconductor layer laminated on the insulator layer, wherein the insulator layer is made of the nitride insulator material according to any one of the first to fifth aspects.

Specifically, since this heat flow switching element comprises: an N-type semiconductor layer; an insulator layer laminated on the N-type semiconductor layer; and a P-type semiconductor layer laminated on the insulator layer, electric charge is induced mostly at the interfaces between the P-type semiconductor layer, the N-type semiconductor layer, and the insulator layer when an external voltage is applied to the N-type semiconductor layer and the P-type semiconductor layer, and the resultant electric charge can transfer heat, whereby the thermal conductivity can be changed.

In particular, since the insulator layer is made of the nitride insulator material according to any one of the first to third aspects, the insulator layer can have low lattice thermal conductivity and therefore low thermal effusivity, whereby the rate of change in the thermal conductivity can be greatly increased by application of an external electric field (external voltage).

In addition, when the N-type semiconductor layer and the P-type semiconductor layer are made of a nitride, the bondability of the interfaces between the P-type semiconductor layer, the N-type semiconductor layer, and the insulator layer can be enhanced because the insulator layer also consists of a nitride.

An increase rate Δk of thermal conductivity after applying a voltage, which is one of the heat flow switch performance can be evaluated by the following equations:

$$\Delta k = k(V)/k(0)-1,$$

and

$$\Delta k = b(V)^2/b(0)^2-1$$

wherein, k(V): thermal conductivity after applying a voltage (W/mK),
k(0): thermal conductivity without applying a voltage (W/mK),
b(V): thermal effusivity after applying a voltage (Ws$^{0.5}$/m$^2$K), and
b(0): thermal effusivity without applying a voltage (Ws$^{0.5}$/m$^2$K).

The thermal conductivity derived from the interface that is changed by applying an external voltage as described above is defined as "third thermal conductivity" in order to distinguish it from the thermal conductivity inherent to the material that is not changed by applying an external voltage (which is addition of the lattice thermal conductivity and the electronic thermal conductivity) for convenience.

That is, k(V) = Electronic thermal conductivity of semiconductor + Lattice thermal conductivity of semiconductor + Lattice thermal conductivity of insulator + Third thermal conductivity, and k(0) = Electronic thermal conductivity of semiconductor + Lattice thermal conductivity of semiconductor + Lattice thermal conductivity of insulator. Therefore, in order to enhance the heat flow switch performance, it is preferable to choose a material having low electronic thermal conductivity and lattice thermal conductivity. As to the electronic thermal conductivity of semiconductor, the electronic thermal conductivity inherent to the material in a zero-bias state needs to be adjusted to an appropriate value to the extent so as not increase the total thermal conductivity in order to maintain the conduction of the semiconductor. As to the lattice thermal conductivity, since a material having low lattice thermal conductivity can make k(0) small and allow the thermal conductivity throughout the entire element to be decreased in a zero-bias state, the lower the lattice thermal conductivity is, the more contribution of the electronic thermal conductivity can be made in response to the external electric field from zero bias, whereby the rate of change in the thermal conductivity according to an external electric field can be greatly increased, thereby enhancing the heat flow switch performance.

Note that, since electric charge is produced at both the interface between the N-type semiconductor layer and the insulator layer or the vicinity thereof and the interface between the P-type semiconductor layer and the insulator layer or the vicinity thereof, a large amount of electric charge is produced, whereby the thermal conductivity can be greatly changed and high thermal responsivity can be obtained. In addition, since the thermal conductivity is not chemically but physically changed, the thermal conductivity can be immediately changed and a good thermal responsivity can be obtained.

In addition, since the amount of electric charge induced at the interface varies by multiplication of the magnitude of external voltage, the thermal conductivity can be adjusted by adjusting the external voltage, and thus heat flow can be actively controlled by the present device.

Note that, since the insulator layer functions as an insulator, where electric current is not produced by application of a voltage, Joule heat is not produced. Therefore, heat flow can be actively controlled without self-heating.

A heat flow switching element according to a seventh aspect of the present invention is characterized by the heat flow switching element according to the sixth aspect comprising: an upper high-thermally-conductive portion provided on the uppermost surface; a lower high-thermally-conductive portion provided on the lowermost surface; and an outer periphery heat insulating portion provided so as to cover outer periphery edges of the N-type semiconductor layer, the insulator layer, and the P-type semiconductor layer, wherein the outer periphery heat insulating portion is made of the nitride insulator material having thermal conductivity lower than those of the upper high-thermally-conductive portion and the lower high-thermally-conductive portion.

Specifically, in this heat flow switching element, since the outer periphery heat insulating portion is made of the nitride insulator material having thermal conductivity lower than those of upper high-thermally-conductive portion and lower high-thermally-conductive portion, heat flow in the in-plane direction can be suppressed, and thus heat flow switching performance can be obtained in the laminated direction. In particular, when an N-side electrode and a P-side electrode are arranged at the outer periphery of each of the layers, heat flow into these electrodes can be suppressed as much as possible by the outer periphery heat insulating portion having low thermal conductivity.

A thermoelectric conversion element according to an eighth aspect of the present invention comprises: an electrical insulation substrate; a P-type thermoelectric conversion portion and an N-type thermoelectric conversion portion formed on the electrical insulation substrate; a connecting electrode portion for connecting the P-type thermoelectric conversion portion and the N-type thermoelectric conversion portion; and an insulator provided so as to cover the surfaces of the P-type thermoelectric conversion portion and the N-type thermoelectric conversion portion, wherein the insulator is made of the nitride insulator material according to any one of the first to fifth aspects of the present invention.

Specifically, in this thermoelectric conversion element, since the insulator is made of the nitride insulator material according to any one of the first to fifth aspects, the surface of the thermoelectric conversion portion is covered with such an insulator made of the nitride insulator material having low thermal conductivity, whereby heat radiated from the surface of the thermoelectric conversion portion can be suppressed and the temperature difference between the high-temperature side and the low-temperature side can be sufficiently ensured.

In addition, when the P-type thermoelectric conversion portion and the N-type thermoelectric conversion portion are made of a nitride, the bondability of the interfaces between the P-type semiconductor layer, the N-type semiconductor layer, and the insulator layer can be enhanced because the insulator is also made of a nitride.

A thermoelectric conversion element according to a ninth aspect of the present invention is characterized by the thermoelectric conversion element according to the eighth aspect, wherein each of the P-type thermoelectric conversion portion, the N-type thermoelectric conversion portion, and the insulator is formed as a film.

Specifically, in this thermoelectric conversion element, since the P-type thermoelectric conversion portion, each of the N-type thermoelectric conversion portion, and the insulator is formed as a film, the device can be made thinner as a whole.

A method for producing a nitride insulator material according to a tenth aspect of the present invention is a method for producing the nitride insulator material according to any one of the first to fifth aspects, wherein a film deposition is performed by reactive sputtering in a nitrogen-containing atmosphere using an M-Si-Te sputtering target (where M represents at least one of Ta and Hf, and Te is an arbitrary element).

Specifically, since in this method for producing a nitride insulator material, a film deposition is performed by reactive sputtering in a nitrogen-containing atmosphere using an M-Si-Te sputtering target (where M represents at least one of Ta and Hf, and Te is an arbitrary element), a nitride insulator layer or film can be obtained that consists of a metal nitride represented by the general formula: M-Si-N-Te (where M represents at least one of Ta and Hf, and Te is an arbitrary element) and has a nanocrystalline structure as well as a small surface roughness.

Advantageous Effects of Invention

According to the present invention, the following effects may be provided.

Specifically, since the nitride insulator material of the present invention consists of a metal nitride represented by the general formula: M-Si-N-Te (where M represents at least one of Ta and Hf, and Te is an arbitrary element) and has a nanocrystalline structure, low thermal conductivity indicating low thermal effusivity can be obtained due to the electrical insulation and the low lattice thermal conductivity. Therefore, the nitride insulator material of the present invention is suitable for electric and thermal barrier materials (electric and thermal insulation materials).

In addition, in the heat flow switching element of the present invention, since the insulator layer is made of the above-described nitride insulator material of the present invention, the insulator layer having low lattice thermal conductivity can increase the rate of change in the thermal conductivity according to an external electric field, thereby enhancing the heat flow switch performance.

In addition, in the thermoelectric conversion element of the present invention, since the insulator is made of the above-described nitride insulator material of the present invention, the insulator can have low lattice thermal conductivity, whereby the heat radiated from a surface of the thermoelectric conversion portion can be suppressed, and the temperature difference between the high-temperature side and the low-temperature side can be sufficiently ensured.

Brief Description of Drawings

FIG. 1 is a perspective view showing a heat flow switching element according to a first embodiment of a nitride insulator material, a method for producing the same, and a heat flow switching element of the present invention.

FIG. 2 is a conceptual diagram for illustrating the principle of the heat flow switching element according to the first embodiment.

FIG. 3 is a cross-sectional view showing a heat flow switching element according to a second embodiment of a nitride insulator material, a method for producing the same, and a heat flow switching element of the present invention.

FIG. 4 is a perspective view showing a thermoelectric conversion element according to a third embodiment of a nitride insulator material, a method for producing the same, and a thermoelectric conversion element of the present invention.

FIG. 5 is a cross-sectional view showing a thermoelectric conversion element according to a fourth embodiment of a nitride insulator material, a method for producing the same, and a thermoelectric conversion element of the present invention.

FIG. 6 is a diagram illustrating the arrangement for the electrical insulation evaluation test in Examples of a nitride insulator material, a method for producing the same, a heat flow switching element, and a thermoelectric conversion element of the present invention.

FIG. 7 is a graph showing the XRD pattern according to Examples of the present invention.

FIG. 8 shows the cross-sectional SEM image of the material according to Example of the present invention.

FIG. 9 shows the cross-sectional SEM images of the materials according to Examples 7(a) and 25(b) of the present invention.

FIG. 10 shows the TEM images of the materials according to Examples 7(a) and 25(b) of the present invention.

FIG. 11 shows the diffraction pattern images of the materials according to Examples 7(a) and 25(b) of the present invention.

Description of Embodiments

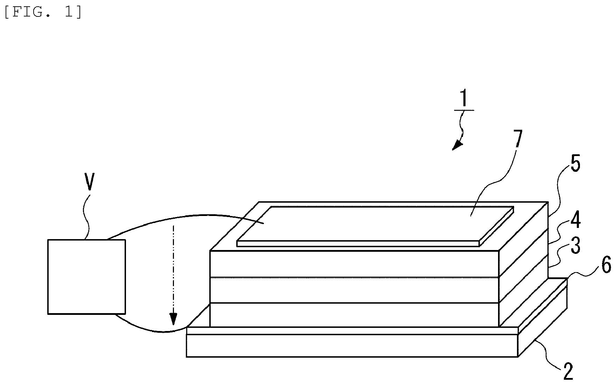

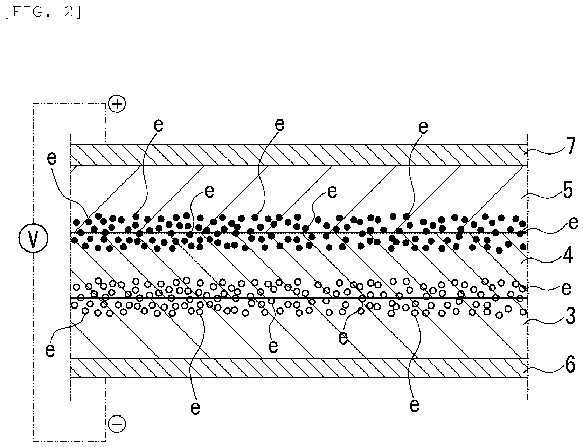

Hereinafter, a nitride insulator material, a method for producing the same, a heat flow switching element, and a thermoelectric conversion element according to a first embodiment of the present invention will be described with reference to FIGs. 1 and 2. In the drawings used in the following description, the scale of each component is changed as appropriate so that each component is recognizable or is readily recognized.

As shown in FIGs. 1 and 2, a heat flow switching element 1 according to the present embodiment includes: an N-type semiconductor layer 3; an insulator layer 4 laminated on the N-type semiconductor layer 3; and a P-type semiconductor layer 5 laminated on the insulator layer 4.

Furthermore, the heat flow switching element 1 according to the present embodiment includes an N-side electrode 6 connected to the N-type semiconductor layer 3 and a P-side electrode 7 connected to the P-type semiconductor layer 5.

The insulator layer 4 is made of an nitride insulator material having low thermal conductivity that consists of a metal nitride represented by the general formula: M-Si-N-Te (where M represents at least one of Ta and Hf, and Te is an arbitrary element) and has a nanocrystalline structure.

Note that a material having a crystal size of 5 nm or less including being an amorphous state is herein referred to as a nanocrystal.

In addition, a crystal size is measured by randomly choosing ten crystals in a cross-sectional TEM image so as to calculate the mean value of the equivalent circle diameter thereof.

The insulator layer 4 consists of a metal nitride represented by the general formula: M-Si-N-Te (where M represents at least one of Ta and Hf, and Te is an arbitrary element), wherein the metal nitride has a composition of Ta-Si-N, Hf-Si-N, Ta-Hf-Si-N, or Ta-Si-N-Te.

In addition, the N-type semiconductor layer 3 and the P-type semiconductor layer 5 are made of a nitride semiconductor material having low thermal conductivity that consists, for example, of a metal nitride represented by the general formula: A-Si-N-Te (where A represents at least one of transition metal elements, and Te is an arbitrary element) and have a nanocrystalline structure.

Specifically, the above-described metal nitrides can have a composition of Cr-Si-N, Mn-Si-N, Ni-Si-N, Mo-Si-N, W-Si-N, Cr-W-Si-N, Cr-Si-N-Te, W-Si-N-Te, or the like.

These metal nitrides are deposited as a film by various deposition methods including a sputtering method, a molecular beam epitaxy method (MBE method), or the like.

As to a sputtering method, the above-described metal nitrides can be deposited as a film using sputtering targets having various composition ratios in a sputtering apparatus under a mixed gas atmosphere of Ar gas + nitrogen gas by varying a sputtering gas pressure, a nitrogen gas partial pressure, or the like.

In the present embodiment, the insulator layer 4 made of the nitride insulator material is deposited by reactive sputtering in a nitrogen-containing atmosphere using an M-Si-Te (where M represents at least one of Ta and Hf, and Te is an arbitrary element) sputtering target.

Note that a trace amount of oxygen(O) may be contained in the film as an inevitable impurity during deposition.

In addition, when a voltage can be directly applied to the N-type semiconductor layer 3 and the P-type semiconductor layer 5, the N-side electrode 6 and the P-side electrode 7 are not required.

The heat flow switching element 1 according to the present embodiment also includes an insulating substrate 2 on which the N-side electrode 6 is formed. Specifically, on the substrate 2, the N-side electrode 6, the N-type semiconductor layer 3, the insulator layer 4, the P-type semiconductor layer 5, and the P-side electrode 7 are laminated in this order. Note that, they may be laminated on the substrate 2 in its reverse order. In addition, the substrate 2 itself may be used as the P-side electrode 7 or the N-side electrode 6.

An external power source V is connected to the N-side electrode 6 and the P-side electrode 7, to which a voltage is applied. Note that the arrow in FIG. 1 denotes the direction of a voltage (electric field) application.

The N-type semiconductor layer 3 and the P-type semiconductor layer 5 are formed as a thin film having a thickness of less than 1 um. In particular, since electric charge "e" (positive electric charge, negative electric charge) that is produced at the interface with the insulator layer 4 or the vicinity thereof are mostly accumulated within the area having a thickness of 5 to 10 nm, the N-type semiconductor layer 3 and the P-type semiconductor layer 5 are preferably formed with a film thickness of 100 nm or less. Note that the N-type semiconductor layer 3 and the P-type semiconductor layer 5 preferably has a film thickness of 5 nm or more.

In addition, the insulator layer 4 preferably has a film thickness of 40 nm or more, and the thickness is set as not to cause electrical breakdown. Note that since the insulator layer 4 having a too large thickness makes it difficult to carry the electric charge "e", the film thickness is preferably set to be less than 1 $\mu$m.

Note that, in FIG. 2, the electric charge "e" produced at the interface between the N-type semiconductor layer 3 and the insulator layer 4 or the vicinity thereof is an electron, which is depicted as an open circle. In addition, the electric charge "e" produced at the interface between the P-type semiconductor layer 5 and the insulator layer 4 or the vicinity thereof is an electron hole, which is depicted as a filled circle. (Since the electron hole is produced due to the shortage of electron in the valence band of the semiconductor, it relatively seems to have a positive electric charge.)

The type of the semiconductor layer, that is, whether the N-type semiconductor layer 3 or the P-type semiconductor layer 5, depends on the content of nitrogen(N). Note that this type can be also set by adding a metal element as a dopant that exhibits the N-type or P-type to the above-described nitride semiconductor material.

The substrate 2 can include, for example, a glass substrate or the like.

The N-side electrode 6 and the P-side electrode 7 are made of a metal such as, for example, Mo, Al, or the like.

As shown in FIG. 2, in the heat flow switching element 1 according to the present embodiment, the electric charge "e" capable of conducting heat is produced at the interface between the N-type semiconductor layer 3 and the insulator layer 4 or the vicinity thereof by application of an electric field (voltage) and the resultant electric charge "e" can transfer heat, whereby the thermal conductivity can be changed.

For greatly changing the thermal conductivity by the electric charge produced at the interface or the vicinity thereof by application of an electric field (voltage), a material having low lattice thermal conductivity is suitable. Therefore, the nitride insulator material according to the present embodiment has low lattice thermal conductivity, i.e., low thermal conductivity.

In addition, the third thermal conductivity as defined above increases depending on the amount of the electric charge "e" that is produced by application of an external electric field (voltage).

Note that, since the electric charge "e" is produced at the interfaces between the N-type semiconductor layer 3, the P-type semiconductor layer 5, and the insulator layer 4, the increase of the total area of the interfaces can also increase the amount of the electric charge "e".

The thermal conductivity is measured using, for example, a pulsed light heating thermoreflectance method, where a thin film sample formed on a substrate is instantaneously heated by pulsed laser so as to calculate the thermal diffusivity or thermal effusivity in the film thickness direction by measuring the decreasing rate of the surface temperature due to the thermal diffusivity into the inside of the thin film or the increasing rate of the surface temperature. Note that when using a method for directly measuring the thermal diffusivity (a Rear Heating/Front Detection (RF) method) among pulsed light heating thermoreflectance methods, a transparent substrate needs to be used such that pulsed laser can transmit therethrough. If a transparent substrate is not used, the thermal conductivity is measured by a Front Heating/Front Detection (FF) method, where the thermal effusivity is measured and converted into the thermal conductivity. Note that this measurement requires a metal film, and Mo, Al, or the like can be used.

In the present embodiment, the thermal effusivity is measured using a Front Heating/Front Detection (FF) method.

In the heat flow switching element 1 according to the present embodiment, since the electric charge "e" is produced at both the interface between the N-type semiconductor layer 3 and the insulator layer 4 or the vicinity thereof and the interface between the P-type semiconductor layer 5 and the insulator layer 4 or the vicinity thereof, a large amount of electric charge is produced, whereby the thermal conductivity can be greatly changed and a high thermal responsivity can be obtained. In addition, since the thermal conductivity is not chemically but physically changed, the thermal conductivity can be immediately changed and a good thermal responsivity can be obtained.

In addition, since the amount of electric charge that is induced at the interface varies by multiplication of the magnitude of external voltage, the thermal conductivity can be adjusted by adjusting the external voltage, whereby heat flow can be actively controlled by the present device.

Note that, since the insulator layer 4 functions as an insulator, where electric current is not produced by application of a voltage, Joule heat is not produced. Therefore, heat flow can be actively controlled without self-heating.

In addition, when the N-type semiconductor layer 3 and the P-type semiconductor layer 5 consist of a nitride, the bondability of the interfaces between the P-type semiconductor layer, the N-type semiconductor layer, and the insulator layer can be enhanced because the insulator layer 4 also consists of a nitride.

As described above, since the nitride insulator material according to the present embodiment (the insulator layer 4) consists of a metal nitride represented by the general formula: M-Si-N-Te (where M represents at least one of Ta and Hf, and Te is an arbitrary element) and has a nanocrystalline structure, low thermal conductivity indicating low thermal effusivity can be obtained due to the electrical insulation and the low lattice thermal conductivity. Therefore, the insulator layer 4 according to the present embodiment can function as an electric and thermal barrier layer.

Note that the constituent elements M (at least one of Ta and Hf) and Si allow the material to be nanocrystallized (to have a crystal size of 5 nm or less, including amorphous state) and the lattice thermal conductivity to be reduced, thereby decreasing the thermal effusivity. In addition, the content of the constituent element N allows the material to have electrical insulation. Furthermore, the constituent element Te has an effect to further decrease the thermal effusivity.

In particular, with the nitride insulator material according to the present embodiment, a thermal effusivity of less than 2000 $Ws^{0.5}/m^2K$ and an electrical resistivity of $10^8$ Qcm or more can be obtained. Therefore, the nitride insulator material according to the present embodiment can have thermal conductivity lower than that with $HfO_2$, whereby the electrical insulation that only permits electric current of less than 100 $\mu A/mm^2$ to flow by application of a voltage of 10V can be obtained.

Furthermore, the nitride insulator material according to the present embodiment may have a thermal effusivity of less than 1700 $Ws^{0.5}/m^2K$ and an electrical resistivity of $10^8$ Qcm or more. Therefore, such a nitride insulator material can have thermal conductivity lower than that with $HfO_2$ and SiN, whereby the electrical insulation that permits only electric current of less than 100 $\mu A/mm^2$ to flow by application of a voltage of 10V can be obtained. Since the nitride insulator material according to the present embodiment exhibits lower thermal conductivity, i.e., higher insulation, it is more suitable for an insulator layer constituting a heat flow switching element and an insulator layer constituting a thermoelectric conversion element.

Since the heat flow switching element 1 according to the present embodiment includes: the N-type semiconductor layer 3; the insulator layer 4 laminated on the N-type semiconductor layer 3; and the P-type semiconductor layer 5 laminated on the insulator layer 4, the electric charge "e" is induced mostly at the interfaces between the P-type semiconductor layer 5, the N-type semiconductor layer 3, and the insulator layer 4 when an external voltage is applied to the N-type semiconductor layer 3 and the P-type semiconductor layer 5 and the resultant electric charge "e" can transfer heat, whereby the thermal conductivity can be changed.

In particular, since the insulator layer 4 is made of the above-described nitride insulator material, low thermal conductivity indicating low thermal effusivity due to the low lattice thermal conductivity can be obtained in a zero-bias state, whereby the rate of change in the thermal conductivity can be increased by application of an external electric field (external voltage). Specifically, the lower the lattice thermal conductivity is, the more contribution of the thermal conductivity derived from the interface can be made in response to an external electric field from zero bias, which can increase the rate of change in the thermal conductivity according to an external electric field, thereby enhancing the heat flow switch performance.

In the method for producing the nitride insulator material (the insulator layer 4) according to the present embodiment, since a film deposition is performed by reactive sputtering in a nitrogen-containing atmosphere using an M-Si-Te sputtering target (where M represents at least one of Ta and Hf, and Te is an arbitrary element), a nitride insulator layer or film can be obtained that consists of a metal nitride represented by the general formula: M-Si-N-Te (where M represents at least one of Ta and Hf, and Te is an arbitrary element) and has a nanocrystalline structure as well as a small surface roughness.

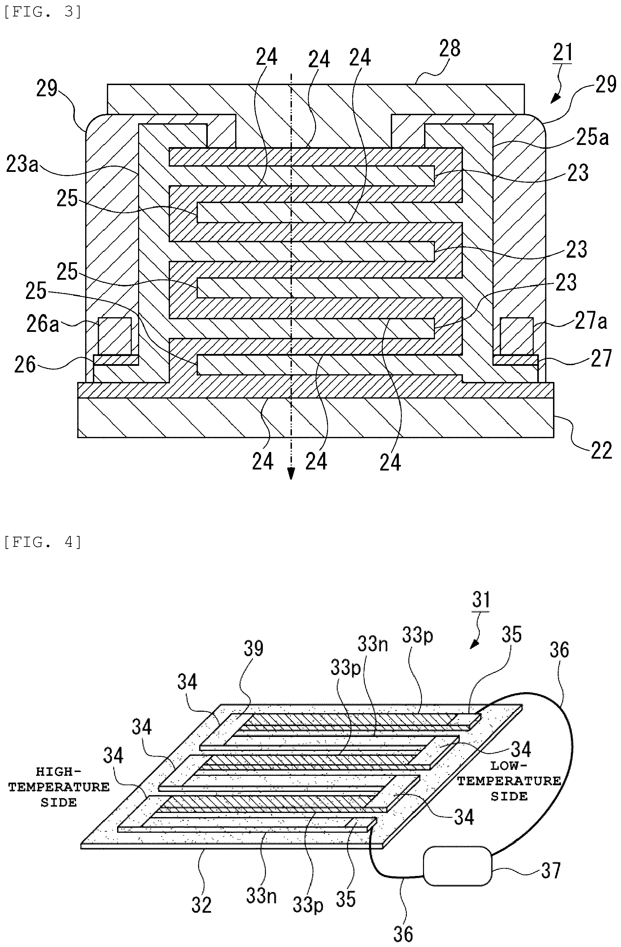

Next, a nitride insulator material, a method for producing the same, a heat flow switching element, and a thermoelectric conversion element according to second and third embodiments of the present invention will be described with reference to FIGs. 3 and 4. Note that, in the following description of each embodiment, the same components as those in the embodiment described above are denoted by the same reference numerals, and thus the description thereof is omitted.

The second embodiment is different from the first embodiment in the following points. In the first embodiment, each one of the N-type semiconductor layer 3, the insulator layer 4, and the P-type semiconductor layer 5 is laminated on each other, whereas in a heat flow switching element 21 according to the second embodiment, as shown in FIG. 3, a plurality of the N-type semiconductor layers 23 and the P-type semiconductor layers 25 are alternately laminated on each other with an insulator layer 24 being sandwiched therebetween.

Specifically, in the second embodiment, firstly the insulator layer 24 is deposited on a substrate 22, on which the N-type semiconductor layer 23 and the P-type semiconductor layer 25 are repeatedly laminated with the insulator layer 24 being sandwiched therebetween in this order so as to form a laminate having three of the N-type semiconductor layers 23, three of the P-type semiconductor layers 25, and seven of the insulator layers 24.

Each of the N-type semiconductor layers 23 is connected to an N-side joint 23a provided on the base end, and further an N-side electrode 26 is formed on a part of the N-side joint 23a. In addition, each of the P-type semiconductor layers 25 is connected to a P-side joint 25a provided on the base end, and further a P-side electrode 27 is formed on a part of the P-side joint 25a.

Each layer described above is patterned using a metal mask. Note that a plurality of the N-type semiconductor layers 23 and the P-type semiconductor layers 25, and the insulator layers 24 are laminated on each other by shifting the position of a metal mask while performing the deposition.

In addition, each of the N-side electrode 26 and the P-side electrode 27 is connected to lead wires 26a and 27a, respectively.

As described above, since in the heat flow switching element 21 according to the second embodiment, a plurality of the N-type semiconductor layers 23 and the P-type semiconductor layers 25 are alternately laminated on each other with the insulator layers 24 being sandwiched therebetween, the amount of the electric charge "e" produced by an external voltage can be increased depending on the increased area of the interface due to the repeated lamination as described above, whereby the thermal conductivity can be greatly change and a high thermal responsivity can be obtained.

In addition, the heat flow switching element 21 according to the second embodiment includes: an upper high-thermally-conductive portion 28 provided on the uppermost surface; the substrate 22 that is a lower high-thermally-conductive portion provided on the lowermost surface; and an outer periphery heat insulating portion 29 provided so as to cover the outer periphery edges of the N-type semiconductor layers 23, the insulator layers 24, and the P-type semiconductor layers 25, wherein the outer periphery heat insulating portion 29 is made of the above-described nitride insulator material having thermal conductivity lower than those of the upper high-thermally-conductive portion 28 and the substrate 22 that is the lower high-thermally-conductive portion.

Specifically, the outer periphery heat insulating portion 29 consists of a metal nitride represented by the general formula: M-Si-N-Te (where M represents at least one of Ta and Hf, and Te is an arbitrary element) and has a nanocrystalline structure.

Note that the insulator layers 24 also preferably consist of a metal nitride represented by the general formula: M-Si-N-Te (where M represents at least one of Ta and Hf, and Te is an arbitrary element) and has a nanocrystalline structure similarly to the outer periphery heat insulating portion 29.

In addition, the upper high-thermally-conductive portion 28 is made of a high thermally-conductive material such as silicon-based resin (silicone) or the like, while the substrate 22 that is the lower high-thermally-conductive portion includes a high-thermally-conductive substrate that is made of alumina or the like.

The outer periphery heat insulating portion 29 is configured to cover the periphery of the insulator layers 24 with a part thereof being exposed at the uppermost portion, while the upper high-thermally-conductive portion 28 is formed on the upper portion so as to be in contact with the insulator layer 24 that is exposed at the uppermost portion.

Note that the outer periphery heat insulating portion 29 is also configured to cover the N-side electrode 26 and the P-side electrode 27 that are arranged on the outer periphery of each of the layers and connected to the lead wires 26a and 27a.

In the second embodiment, since the heat flow direction is the laminated direction (the arrow direction in FIG. 3), the side of the upper high-thermally-conductive portion 28 can be the high-temperature side while the side of the substrate 22 that is the lower high-thermally-conductive portion can be the low-temperature side, for example. If the heat flow direction is in the laminated direction, the side of the upper high-thermally-conductive portion 28 can be the low-temperature side and the side of the substrate 22 that is the lower high-thermally-conductive portion can be the high-temperature side.

As described above, in the heat flow switching element 21 according to the second embodiment, since the outer periphery heat insulating portion 29 is made of the nitride insulator material having thermal conductivity lower than those of the upper high-thermally-conductive portion 28 at the uppermost surface and the substrate 22 that is the lower high-thermally-conductive portion at the lowermost surface, the heat can be suppressed from flowing through the outer periphery heat insulating portion 29, where the thermal conductivity does not change while the N-type semiconductor layers 23, the insulator layers 24, and the P-type semiconductor layers 25 all can be utilized as the heat flow path, whereby the heat flow switching performance can be obtained in the laminated direction.

Next, the difference between the third embodiment and the second embodiment will be described. The second embodiment relates to a heat flow switching element, and the third embodiment relates to a thermoelectric conversion element 31 as shown in FIG. 4.

Specifically, the thermoelectric conversion element 31 according to the third embodiment includes: an electrical insulation substrate 32; a P-type thin film thermoelectric conversion portion 33p and an N-type thin film thermoelectric conversion portion 33n formed on the electrical insulation substrate 32; a connecting electrode portion 34 for connecting the P-type thin film thermoelectric conversion portion 33p and the N-type thin film thermoelectric conversion portion 33n; a pair of electrode terminal portions 35 formed on the ends of the P-type thin film thermoelectric conversion portion 33p and the N-type thin film thermoelectric conversion portion 33n connected to each other; and an insulator film 39 configured so as to cover the surfaces of the electrical insulation substrate 32, the P-type thin film thermoelectric conversion portion 33p, the N-type thin film thermoelectric conversion portion 33n, and the connecting electrode portion 34.

The insulator film 39 is made of the same nitride insulator material as that of the first embodiment. Specifically, the insulator film 39 consists of a metal nitride represented by the general formula: M-Si-N-Te (where M represents at least one of Ta and Hf, and Te is an arbitrary element) and has a nanocrystalline structure.

At least one of the P-type thin film thermoelectric conversion portion 33p and the N-type thin film thermoelectric conversion portion 33n is made of a thermoelectric conversion nitride material.

For example, the above-described thermoelectric conversion nitride material consists of a metal nitride represented by the general formula: $(Cr_{1-x}M_x)_{1-y}N_y$ (where M represents at least one of Ti, V, Mn, Fe, Co, Ni, Cu, Zr, Nb, Mo, Hf, Ta, W, Si, Al, B, and Y, and $0 \leq x < 1.0$, $0.40 \leq y < 0.54$) and has a crystal structure of a cubic NaCl-type (space group: Fm-3m (No. 225)) as well as a P-type or N-type thermoelectric characteristic.

Note that in the present embodiment, although both the P-type thin film thermoelectric conversion portion 33p and the N-type thin film thermoelectric conversion portion 33n are made of the above-described thermoelectric conversion nitride material, the P-type thin film thermoelectric conversion portion may be made of an organic thermoelectric material (a printed material), while the N-type thin film thermoelectric conversion portion 33n may be made of the above-described thermoelectric conversion nitride material.

The P-type thin film thermoelectric conversion portion 33p and the N-type thin film thermoelectric conversion portion 33n are formed in a shape having a plurality of lines or bands that extend in parallel to each other and are alternately arranged side by side. In addition, the ends of the P-type thin film thermoelectric conversion portion 33p and the N-type thin film thermoelectric conversion portion 33n that are adjacent to each other are connected at the connecting electrode portion 34 so as to form one piece of the thin film thermoelectric conversion portion that is folded back several times with the pair of electrode terminal portions 35 being formed at both ends.

The connecting electrode portion 34 and the electrode terminal portion 35 are patterned using a metal of Ag, Ag alloy, or the like.

To the pair of electrode terminal portions 35 is connected a lead wire 36, which is in turn connected to a power source 37.

The electrical insulation substrate 32 is preferably made of a material having low thermal conductivity, including, for example, an electrical insulation film, glass, or the like. The electrical insulation film includes, for example, a polyimide resin sheet. Note that the electrical insulation film may be made of other material including liquid crystal polymer(LCP), polyethylene terephthalate(PET), polyethylene naphthalate(PEN), or the like. In addition, the glass substrate may include an alkali-free glass, an alkali glass plate, a glass film, or the like.

When an electrical insulation film is used for the electrical insulation substrate 32, the thermoelectric conversion element 31 can be of a sheet-type. For example, it can include a sheet-type Peltier element (cooling element) that is configured to convert electric energy into thermal energy and transfer the heat, a sheet-type Seebeck element (thermoelectric generation element) that is configured to convert thermal energy into electric energy and perform temperature difference power generation, a sheet-type thermopile that is configured to function as an infrared sensor based on the principle of thermocouple, or the like.

As described above, in the thermoelectric conversion element 31 according to the third embodiment, since the insulator film 39 is made of the above-described nitride insulator material and the surface of the element is covered with the insulator film 39 made of the nitride insulator material having low thermal conductivity, heat radiated from the surfaces of the P-type thin film thermoelectric conversion portion 33p and the N-type thin film thermoelectric conversion portion 33n can be suppressed, whereby the temperature difference between the high-temperature side and the low-temperature side can be sufficiently ensured.

In addition, when the P-type thin film thermoelectric conversion portion 33p and the N-type thin film thermoelectric conversion portion 33n are made of a nitride, the bondability of the interfaces between the P-type thin film thermoelectric conversion portion 33p, the N-type thin film thermoelectric conversion portion 33n, and the insulator film 39 can be enhanced because the insulator film 39 is also made of a nitride.

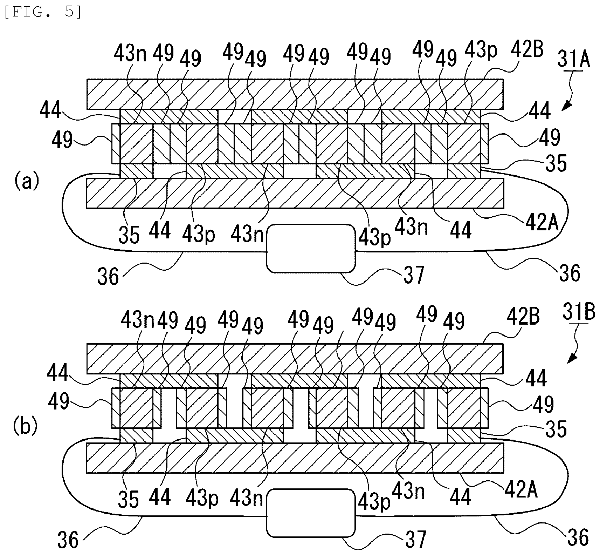

Next, the difference between a fourth embodiment and the third embodiment will be described. In the thermoelectric conversion element according to the third embodiment, the P-type thin film thermoelectric conversion portion 33p and the N-type thin film thermoelectric conversion portion 33n, and the insulator film 39 are all formed as a film, whereas in thermoelectric conversion elements 41A and 41B according to the fourth embodiment, as shown in FIGs. 5(a) and (b), a P-type thermoelectric conversion portion 43p and an N-type thermoelectric conversion portion 43n, and insulators 49 are not formed as a film, but as a bulk.

In addition, in the third embodiment, since the ends of the P-type thin film thermoelectric conversion portion 33p and the N-type thin film thermoelectric conversion portion 33n that are adjacent to each other are connected at the connecting electrode portion 34 on the same plane so as to form one piece of the thin film thermoelectric conversion portion that is folded back several times, whereas in the fourth embodiment, the ends of the P-type thermoelectric conversion portion 43p and the N-type thermoelectric conversion portion 43n formed as a bulk that are adjacent to each other are connected at upper and lower connecting electrode portions 44 so as to form a consecutive thermoelectric conversion portion that is folded back several times on the longitudinal section.

In the present embodiment, the insulators 49 made of the above-described nitride insulator material formed as a bulk are bonded to both sides of each of the P-type thermoelectric conversion portion 43p and the N-type thermoelectric conversion portion 43n so as to cover the sides (surfaces) thereof.

The P-type thermoelectric conversion portion 43p, the N-type thermoelectric conversion portion 43n, the insulators 49, and the connecting electrode portions 44 are arranged so as to be sandwiched between the electrical insulation substrates 42A and 42B.

Note that in the thermoelectric conversion element 41A shown in FIG. 5(a), the insulators 49 that are bonded to the side of the P-type thermoelectric conversion portion 43p and the insulators 49 that are bonded to the side of the N-type thermoelectric conversion portion 43n are in contact with each other. In contrast, in a thermoelectric conversion element 41B shown FIG. 5(b), the insulators 49 that are bonded to the side of the P-type thermoelectric conversion portion 43p and the insulators 49 that are bonded to the side of the N-type thermoelectric conversion portion 43n are not in contact with each other, that is, spaced apart from each other.

As described above, in the thermoelectric conversion elements 41A and 41B according to the fourth embodiment, since the insulators 49 are made of the above-described nitride insulator material and the surfaces (sides) thereof are covered with the insulators 49 that is made of the nitride insulator material having low thermal conductivity, heat radiated from the surfaces can be suppressed even though they are formed as a bulk, whereby the temperature difference between the high-temperature side and the low-temperature side can be sufficiently ensured.

Examples

The nitride insulator materials according to Examples of the present invention were produced based on the first embodiment by depositing the materials described in Tables 2 and 3 below (Ta-Si-N, Hf-Si-N, and Ta-Si-N-Te) on a glass substrate by a reactive sputtering method in a nitrogen-containing atmosphere. Then the measurements of the crystal structure, thermal effusivity, and electrical resistivity thereof were performed. The results of the crystal structures and thermal effusivity are shown in Tables 2 and 3.

Note that the composition of each of the materials according to Examples was set by changing the percentage of nitrogen, i.e., ($N_2$/(Ar+$N_2$)) as well as the Si/(M+Si) ratio.

As the composition analysis, elemental analysis was performed by X-ray photoelectron spectroscopy (XPS). In the XPS, a quantitative analysis was performed on a sputtering surface at a depth of 20 nm from the outermost surface by Ar sputtering. Note that the quantitative accuracy of N/(M+Si+N) and Si/(M+Si) was $\pm2\%$ and $\pm1\%$, respectively.

For the nitride insulator materials according to Comparative Examples produced by depositing materials consisting of Al-N, $HfO_2$, Ta-Si, Hf-Si, and Si-N, the thermal effusivity and the electrical resistivity thereof were also measured. The results of the crystal structure and thermal effusivity thereof are shown in Table 1.

The sputtering was performed using a magnetron sputtering apparatus as follow: a nitride insulator material film having a thickness of 200 nm was deposited on a glass substrate (20 $\times$ 20 $\times$ 0.5 mm) using a RF method and a material of Mo having a thickness of 100 nm was sputtered on the resultant film to provide a device.

Note that a surface roughness Ra of all the nitride insulator material films after the sputtering described above was as small as less than 2 nm. The surface roughness Ra was evaluated using an X-ray reflectivity analysis.

The thermal effusivity described above was measured using a FF (Front Heating/Front Detection) method among pulsed light heating thermoreflectance methods (thin film thermal properties measurement apparatus: PicoTR by PicoTherm Corporation). The measurement was performed at a room temperature.

The thermal conductivity was calculated from the thermal effusivity using the following equation:

$$\text{Thermal conductivity k = (Thermal effusivity b)}^2/\text{Volumetric heat capacity}$$

$$= \text{(Thermal effusivity b)}^2/\text{(Specific heat} \times \text{Density).}$$

[Table 1]

|  | COMPOSITION | CRYSTAL STRUCTURE | THERMAL EFFUSIVITY $Ws^{0.5}/m^2K$ |
|---|---|---|---|
| COMPARATIVE EXAMPLE 1 | AlN | COLUMNAR CRYSTAL | 8507 |
| COMPARATIVE EXAMPLE 2 | HfO2 | NANOCRYSTAL | 2381 |

(continued)

| | COMPOSITION | CRYSTAL STRUCTURE | THERMAL EFFUSIVITY $Ws^{0.5}/m^2K$ |
|---|---|---|---|
| COMPARATIVE EXAMPLE 3 | TaSi Si/(Ta+Si)RATIO =27 (at%) | NANOCRYSTAL | >2500 |
| COMPARATIVE EXAMPLE 4 | HfSi Si/(Hf+Si)RATIO=28.3 (at%) | NANOCRYSTAL | >2500 |
| COMPARATIVE EXAMPLE 5 | SiN | NANOCRYSTAL | 2033 |

[Table 2]

| | COMPOSITION | CRYSTAL STRUCTURE | Ta (at%) | Si (at%) | N (at%) | Si/ (Ta+Si) RATIO (at%) | THERMAL EFFUSIVITY $Ws^{0.5}/m^2K$ |
|---|---|---|---|---|---|---|---|
| EXAMPLE 1 | TaSiN | NANOCRYSTAL | 31.9 | 18.3 | 49.8 | 36.4 | 1538 |
| EXAMPLE 2 | TaSiN | NANOCRYSTAL | 25.3 | 16.1 | 58.6 | 38.8 | 1553 |
| EXAMPLE 3 | TaSiN | NANOCRYSTAL | 26.1 | 17.1 | 56.8 | 39.6 | 1561 |
| EXAMPLE 4 | TaSiN | NANOCRYSTAL | 25.9 | 17.0 | 57.1 | 39.5 | 1485 |
| EXAMPLE 5 | TaSiN | NANOCRYSTAL | 24.8 | 17.2 | 58.0 | 40.9 | 1494 |
| EXAMPLE 6 | TaSiN | NANOCRYSTAL | 28.9 | 15.2 | 55.9 | 34.5 | 1429 |
| EXAMPLE 7 | TaSiN | NANOCRYSTAL | 22.1 | 20.7 | 57.2 | 48.3 | 1406 |
| EXAMPLE 8 | TaSiN | NANOCRYSTAL | 24.7 | 21.8 | 53.5 | 46.8 | 1573 |
| EXAMPLE 9 | TaSiN | NANOCRYSTAL | 22.7 | 19.2 | 58.1 | 45.8 | 1548 |
| EXAMPLE 10 | TaSiN | NANOCRYSTAL | 22.1 | 20.7 | 57.2 | 48.3 | 1509 |
| EXAMPLE 11 | TaSiN | NANOCRYSTAL | 21.4 | 19.6 | 59.0 | 47.8 | 1442 |
| EXAMPLE 12 | TaSiN | NANOCRYSTAL | 23.4 | 19.4 | 57.2 | 45.4 | 1557 |
| EXAMPLE 13 | TaSiN | NANOCRYSTAL | 25.7 | 18.1 | 56.3 | 41.3 | 1480 |
| EXAMPLE 14 | TaSiN | NANOCRYSTAL | 20.4 | 28.7 | 50.9 | 58.5 | 1640 |
| EXAMPLE 15 | TaSiN | NANOCRYSTAL | 19.9 | 28.4 | 51.7 | 58.9 | 1547 |
| EXAMPLE 16 | TaSiN | NANOCRYSTAL | 17.9 | 29.6 | 52.4 | 62.3 | 1510 |
| EXAMPLE 17 | TaSiN | NANOCRYSTAL | 16.4 | 37.1 | 46.4 | 69.3 | 1777 |
| EXAMPLE 18 | TaSiN | NANOCRYSTAL | 14.2 | 33.6 | 52.1 | 70.3 | 1884 |
| EXAMPLE 19 | TaSiN | NANOCRYSTAL | 14.0 | 33.5 | 52.5 | 70.5 | 1927 |
| EXAMPLE 20 | TaSiN | NANOCRYSTAL | 12.3 | 38.2 | 49.5 | 75.6 | 1863 |
| EXAMPLE 21 | TaSiN | NANOCRYSTAL | 9.0 | 44.1 | 46.9 | 83.0 | 1785 |
| EXAMPLE 22 | TaSiN | NANOCRYSTAL | 7.9 | 39.5 | 52.5 | 83.3 | 1971 |
| EXAMPLE 23 | TaSiN | NANOCRYSTAL | 7.5 | 39.6 | 52.9 | 84.1 | 1886 |
| EXAMPLE 24 | TaSiN | NANOCRYSTAL | 5.9 | 40.0 | 54.2 | 87.2 | 1946 |

[Table 3]

| | COMPOSITION | CRYSTAL STRUCTURE | Hf (at%) | Si (at%) | N (at%) | Si/(Hf+Si) RATIO (at%) | THERMAL EFFUSIVITY $Ws^{0.5}/m^2K$ |
|---|---|---|---|---|---|---|---|
| EXAMPLE 25 | HfSiN | NANOCRYSTAL | 30.1 | 15.7 | 54.2 | 34.4 | 1506 |
| EXAMPLE 26 | HfSiN | NANOCRYSTAL | 31.3 | 15.0 | 53.7 | 32.4 | 1499 |
| EXAMPLE 27 | HfSiN | NANOCRYSTAL | 27.6 | 16.6 | 55.8 | 37.6 | 1455 |
| EXAMPLE 28 | HfSiN | NANOCRYSTAL | 21.0 | 25.2 | 53.8 | 54.5 | 1467 |
| EXAMPLE 29 | HfSiN | NANOCRYSTAL | 19.3 | 26.7 | 54.0 | 57.9 | 1504 |
| EXAMPLE 30 | HfSiN | NANOCRYSTAL | 18.1 | 27.4 | 54.5 | 60.1 | 1451 |
| EXAMPLE 31 | HfSiN | NANOCRYSTAL | 17.8 | 27.5 | 54.6 | 60.7 | 1391 |
| EXAMPLE 32 | HfSiN | NANOCRYSTAL | 37.9 | 8.0 | 54.1 | 17.4 | 1421 |
| EXAMPLE 33 | HfSiN | NANOCRYSTAL | 35.8 | 9.2 | 55.0 | 20.5 | 1432 |
| EXAMPLE 34 | HfSiN | NANOCRYSTAL | 35.9 | 10.1 | 54.0 | 22.1 | 1389 |

| | COMPOSITION | CRYSTAL STRUCTURE | Ta (at%) | Si (at%) | N (at%) | Te (at%) | Si/(Ta+Si) RATIO(at%) | THERMAL EFFUSIVITY $Ws^{0.5}/m^2K$ |
|---|---|---|---|---|---|---|---|---|
| EXAMPLE 35 | TaSiNTe | NANOCRYSTAL | 21.6 | 27.5 | 42.6 | 8.4 | 56.0 | 250 |

These results show that the material according to each Example of the present invention all has a thermal effusivity of less than 2000 $Ws^{0.5}/m^2K$, i.e., low thermal conductivity. In addition, the materials according to Comparative Examples all had a thermal effusivity of 2000 $Ws^{0.5}/m^2K$ or more, whereas in particular, the materials according to Examples of the present invention consisting of Hf-Si-N, Ta-Si-N-Te, and Ta-Si-N containing Ta at 17.9 at% or more had a thermal effusivity of less than 1700 $Ws^{0.5}/m^2K$, i.e., low thermal conductivity.

When the amount of Ta in the material consisting of Ta-Si-N is increased, the thermal effusivity tends to decrease and the volumetric heat capacity tends to increase. When the material contains Ta at 17.9 at% or more, the material can have low thermal conductivity of less than 1 $Ws^{0.5}/m^2K$, i.e., high thermal insulation.

Furthermore, the thermal effusivity of the material containing Te according to Example 35 (Ta-Si-N-Te) was found to be 250 $Ws^{0.5}/m^2K$. The material according to Example 35 was found to have a very low thermal effusivity compared to those of Examples 1 to 34, i.e., a low thermal conductivity of less than 1000 $Ws^{0.5}/m^2K$. Since the material according to Example 35 exhibited very low thermal conductivity, i.e., very high thermal insulation, it is more suitable for an insulator layer constituting a heat flow switching element and an insulator layer constituting a thermoelectric conversion element.

Note that the electrical resistivity of the material according to each Example of the present invention was $10^8$ Qcm or more, indicating high electrical insulation. Note that both the materials according to Comparative Examples 3 and 4 made of a metal compound containing no nitrogen were found to have an electrical resistivity of less than 10 Qcm. The materials according to Comparative Examples 1, 2, and 5 exhibited an electrical resistivity of $10^8$ Qcm or more, i.e., high electrical insulation, however all of which were found to be high thermally-conductive materials having a thermal effusivity of 2000 $Ws^{0.5}/m^2K$ or more.

Although both the material according to the Example consisting of M-Si-N-Te (where M represents at least one of Ta and Hf, and Te is an arbitrary element) and the material according to Comparative Example 5 consisting of Si-N were found to have an electrical resistivity of $10^8$ Qcm or more, the materials according to Examples, which contained a heavy metal element Ta or Hf, were found to have a lower lattice thermal conductivity, i.e., lower thermal effusivity, than that with Si-N.

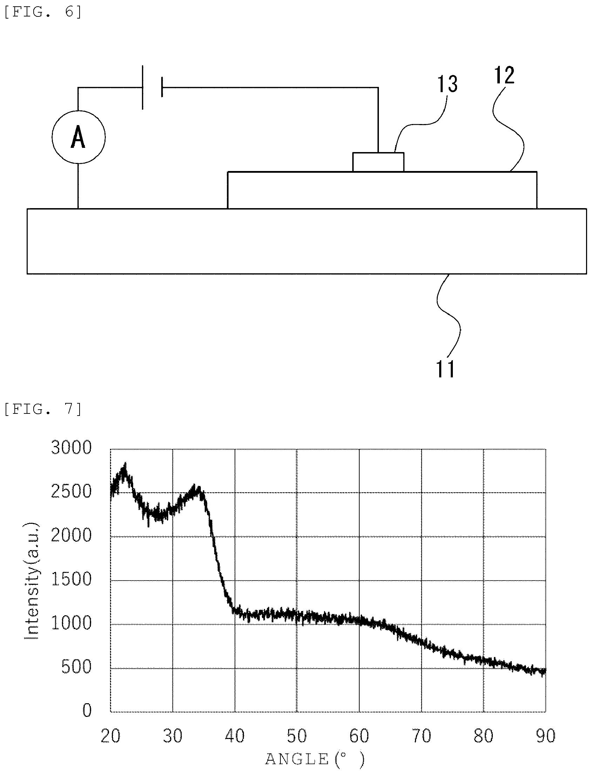

The measurement of this electrical resistivity (electrical insulation evaluation test) was conducted under the arrangement shown in FIG. 6. The measurement was performed at a room temperature. Specifically, the nitride insulator material of the present invention consisting of a M-Si-N-Te (where M represents at least one of Ta and Hf, and Te is an arbitrary element) thin film (100 mm) 12 was deposited on an Si substrate 11, on which an Mo electrode 13 having a thickness of 50 nm was further deposited. Then, a voltage was applied between the Si substrate 11 and the Mo electrode 13 using a high voltage source meter to measure the electric current value at that time, based on which the electrical resistivity was calculated. Since the M-Si-N-Te thin film (100 mm) 12 had a 100 times larger area than that of the Mo electrode 13, when the Mo electrode 13 was placed almost in the center of the M-Si-N-Te thin film (100 mm) 12, the surface electric current was able to be suppressed from being flown into the outer periphery of the M-Si-N-Te thin film 12, whereby the electrical resistivity of the film itself was able to be measured.

As can be seen from Tables 2 and 3, the material according to each Example of the present invention all exhibited a nanocrystalline structure, while the material consisting of Al-N according to Comparative Example 1 exhibited a columnar crystal. The thermal effusivity of the material according to Comparative Example 1 consisting of an Al-N columnar crystal had a value greatly exceeding 2000 $Ws^{0.5}/m^2K$.

Although the materials according to Comparative Example 2 consisting of $HfO_2$, Comparative Example 3 consisting of Ta-Si, Comparative Example 4 consisting of Hf-Si, and Comparative Example 5 consisting of Si-N all exhibited a nanocrystalline structure, but the thermal effusivity thereof was 2000 $Ws^{0.5}/m^2K$ or more. In particular, the materials according to Comparative Example 3 consisting of Ta-Si and Comparative Example 4 consisting of Hf-Si that were made of metal compounds containing no nitrogen exhibited a high thermal effusivity of 2500 $Ws^{0.5}/m^2K$ or more.

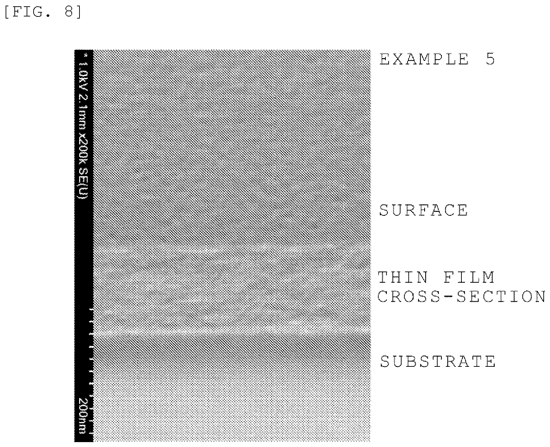

Next, the material according to Example 5 in Table 2 will be described regarding the XRD pattern (in which a fully automatic multi-purpose X-ray diffraction apparatus (SmartLab by Rigaku Corporation) is used) shown in FIG. 7 and the cross-sectional SEM image (slant angle of 45 degrees, magnification of 200000 times) shown in FIG. 8. This cross-sectional SEM image was obtained by breaking the substrates by cleavage. Both the cross-sectional structure and the surface structure of a Ta-Si-N film are shown in FIG. 8. The material according to Example 5 of the present invention was found to have a high surface smoothness and a dense structure, that is, high density.

The thin film XRD was performed by Grazing Incidence X-ray Diffraction (thin film XRD) under the conditions of a vessel of Cu and the angle of incidence of 1 degree. No sharp peak indicating a long-period crystallinity, which means that the crystal size is relatively large, was detected.

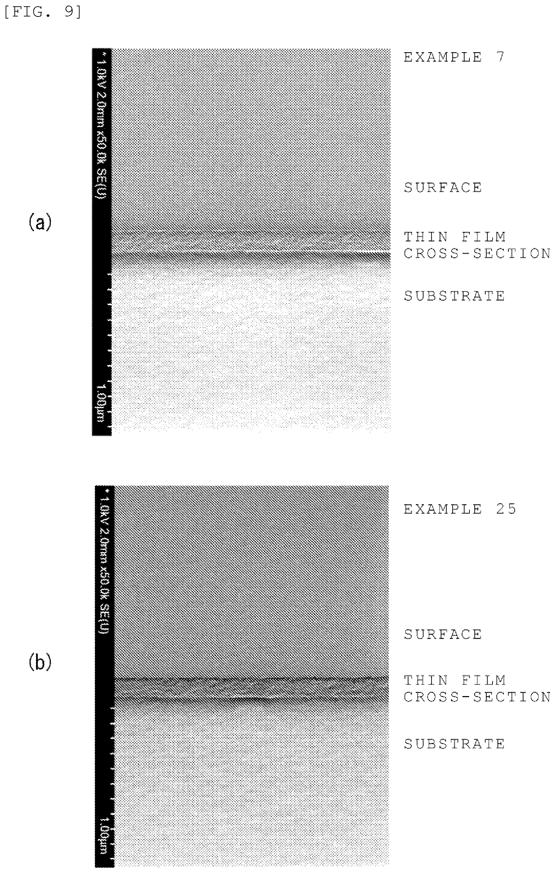

In addition, the cross-sectional SEM images (a slant angle of 45 degrees, magnification of 50000 times) of the materials according to Examples 7 and 25 of the present invention are shown in FIG. 9. These cross-sectional SEM images were obtained by breaking the substrates by cleavage. In FIG. 9, both the cross-sectional structures and surface structures of Ta-Si-N and Hf-Si-N films are shown. The materials according to Examples 7 and 25 of the present invention were found to have a high surface smoothness and a dense structure, that is, high density.

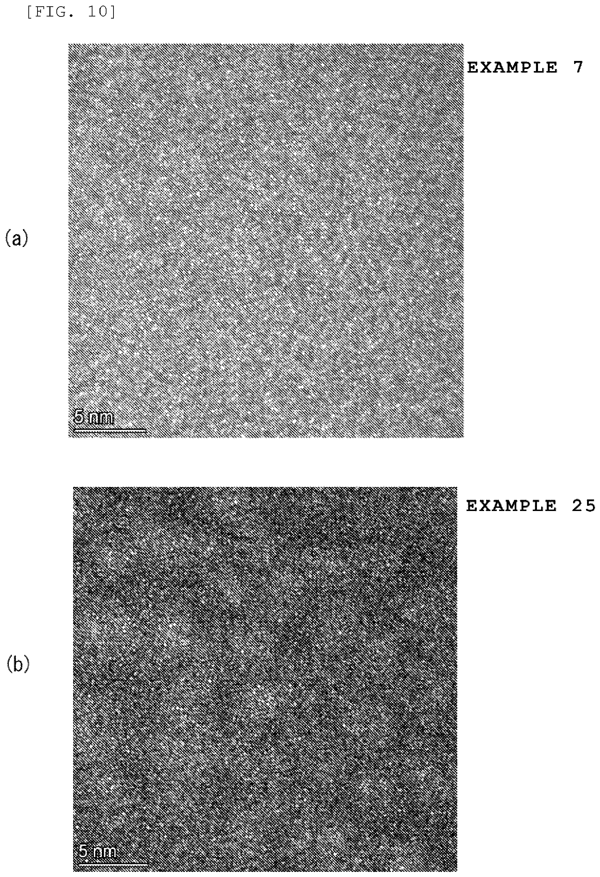

Furthermore, the cross-sectional TEM/HAADF-STEM (an abbreviation of "High-angle annular dark-field scanning transmission electron microscopy") images of the materials according to Examples 7 and 25 are shown in FIG. 10. Note that the magnification of these TEM images is 1050000 times.

As can be seen from these images, the crystal structures of the materials according to Examples 7 and 25 of the present invention were found to have dense nanocrystalline structures having a crystal size of 5 nm or less. Note that the materials having a crystal size of 5 nm or less is herein defined as a nanocrystal including amorphous state.

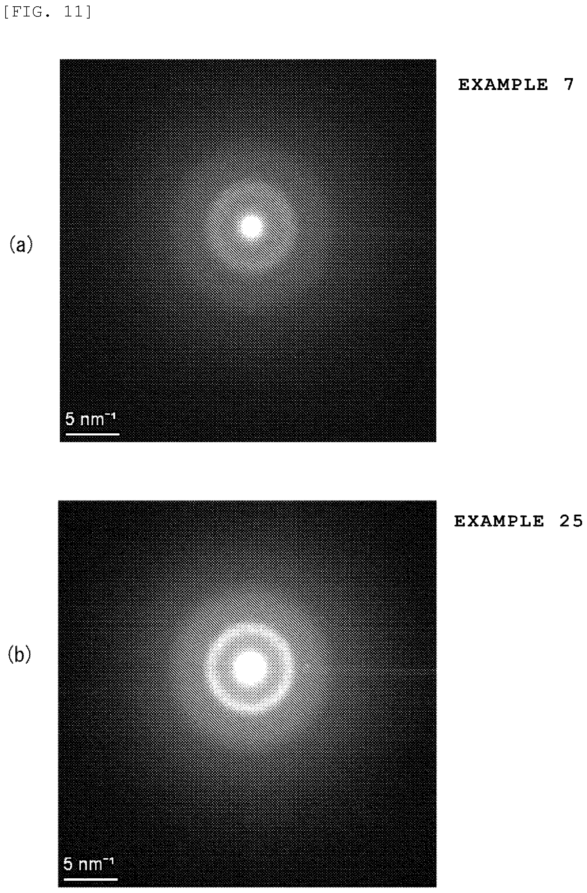

Next, a precise analysis was performed on the cross-sectional structures of the materials consisting of Ta-Si-N and Hf-Si-N using a TEM apparatus. The electron beam diffraction images of the cross-sections of the films according to Examples 7 and 25 are shown in FIG. 11. No electron beam diffraction image indicating long-period crystallinity, which means that the crystal size is relatively large, was detected, which indicates that they are nanocrystals having a very small crystal size or being amorphous. From the observation results of the TEM images, the materials according to Examples were found to have a dense nanocrystalline structure having a crystal size of 5 nm or less. These images also show that the material according to Example 25 has a clearer diffraction ring than that of the material according to Example 7, that is, the material according to Example 7 consisting of Ta-Si-N was found to be a nanocrystal having a smaller crystal size than that of the material according to Example 25 consisting of Hf-Si-N.

Grazing Incidence X-ray Diffraction (thin film XRD) was also performed. A peak, which indicated that a film was crystallized, was detected for the columnar crystal material according to the Comparative Example, whereas no sharp peak indicating a long-period crystallinity, which means that the crystal size is relatively large, was detected for the materials according to Examples. The results of XRD, SEM, and TEM show that the materials according to the present Examples are crystals having a small crystal size of 5 nm or less or being amorphous.

Furthermore, the nanocrystalline films of Examples were found to have a high surface smoothness (surface roughness Ra of less than 2 nm) and a dense structure, that is, high density.

Specifically, the low thermal conductivity (high thermal insulation) does not mean that it is because the present nitride material has voids or the like or has a small density, but means that because the present nitride material itself has low thermal conductivity. These results show that the thermal conductivity that is caused by vibration (phonon, lattice vibration) transmitting between the crystal lattices can be decreased by nanocrystallizing crystals, and thus decreasing the lattice thermal conductivity, whereby a low thermally conductive semiconductor material having a thermal effusivity of less than 2000 $Ws^{0.5}/m^2K$ can be obtained. Furthermore, in particular, the materials according to Examples of the present invention consisting of Hf-Si-N, Ta-Si-N-Te, and Ta-Si-N containing Ta at 17.9 at% or more exhibited low thermal conductivity with a thermal effusivity of less than 1700 $Ws^{0.5}/m^2K$.

In addition, the thermal effusivity of the material according to Example 35 containing Te (Ta-Si-N-Te) was found to be a 250 $Ws^{0.5}/m^2K$, indicating that it was a very low-thermally-conductive material having a thermal effusivity of less than 1000 $Ws^{0.5}/m^2K$. For the material according to Example 35, XRD, SEM, and TEM were performed to confirm that it was a nanocrystalline film having a crystal size of 5 nm or less. Furthermore, the material according to Example 35 was also found to have a high surface smoothness (surface roughness Ra of less than 2 nm) and a dense structure, that is, high density. Specifically, as for the material according to Example 35 containing Te (Ta-Si-N-Te), the low thermal conductivity (high thermal insulation) does not also mean that it is because the nitride material containing Te has voids or the like or a small density, but means that because the nitride material containing Te itself has low thermal conductivity. Since it exhibited very low thermal conductivity, i.e., very high thermal insulation, it is more suitable for an insulator layer constituting a heat flow switching element and an insulator layer constituting a thermoelectric conversion element.

Note that, as to the composition range of each element of M-Si-N-Te for the materials according to Examples 1 to 35, M was 5.9 to 37.9 at%, Si is 8.0 to 44.1 at%, N is 42.6 to 59.0 at%, and Te is 0 to 8.4% with the total percentage of the elements being 100 at%. In addition, that of Si/(M+Si) was 17.4 to 87.2 at%.

The technical scope of the present invention is not limited to the aforementioned embodiments and Examples, but the present invention may be modified in various ways without departing from the scope or teaching of the present invention.

Reference Signs List

1, 21: heat flow switching elements, 3, 23: N-type semiconductor layers, 4, 24: insulator layers, 5, 25: P-type semiconductor layers, 22: substrate (lower high-thermally-conductive portion), 28: upper high-thermally-conductive portion, 29: outer periphery heat insulating portion, 31, 41A, and 41B: thermoelectric conversion elements, 32: electrical insulation substrate, 33p: P-type thin film thermoelectric conversion portion, 43p: P-type thermoelectric conversion portion, 33n: N-type thin film thermoelectric conversion portion, 43n: N-type thermoelectric conversion portion, 34, 44: connecting electrode portions, 39: insulator film, 49: insulator.

**Claims**

1. A nitride insulator material consisting of a metal nitride represented by the general formula: M-Si-N-Te (where M represents at least one of Ta and Hf, and Te is an arbitrary element) and having a nanocrystalline structure.

2. The nitride insulator material according to claim 1, wherein the thermal effusivity is less than 2000 $Ws^{0.5}/m^2K$.

3. The nitride insulator material according to claim 2, wherein the thermal effusivity is less than 1700 $Ws^{0.5}/m^2K$.

4. The nitride insulator material according to claim 1, wherein the electrical resistivity is $10^8$ Qcm or more.

5. The nitride insulator material according to claim 1, wherein the nitride insulator material is used as a low-thermally-conductive material.

6. A heat flow switching element comprising:

   an N-type semiconductor layer;
   an insulator layer laminated on the N-type semiconductor layer; and
   a P-type semiconductor layer laminated on the insulator layer,
   wherein the insulator layer is made of the nitride insulator material according to claim 1.

7. The heat flow switching element according to claim 6 comprising:

   an upper high-thermally-conductive portion provided on the uppermost surface;
   a lower high-thermally-conductive portion provided on the lowermost surface; and
   an outer periphery heat insulating portion provided so as to cover outer periphery edges of the N-type semiconductor layer, the insulator layer, and the P-type semiconductor layer,
   wherein the outer periphery heat insulating portion is made of the nitride insulator material having thermal conductivity lower than those of the upper high-thermally-conductive portion and the lower high-thermally-conductive portion.

8. A thermoelectric conversion element comprising:

   an electrical insulation substrate;
   a P-type thermoelectric conversion portion and an N-type thermoelectric conversion portion formed on the electrical insulation substrate;
   a connecting electrode portion for connecting the P-type thermoelectric conversion portion and the N-type thermoelectric conversion portion; and
   an insulator provided so as to cover the surfaces of the P-type thermoelectric conversion portion and the N-type thermoelectric conversion portion,
   wherein the insulator is made of the nitride insulator material according to claim 1.

9. The thermoelectric conversion element according to claim 8, wherein each of the P-type thermoelectric conversion portion, the N-type thermoelectric conversion portion, and the insulator is formed as a film.

10. A method for producing the nitride insulator material according to claim 1, wherein a film deposition is performed by reactive sputtering in a nitrogen-containing atmosphere using an M-Si-Te sputtering target (where M represents at least one of Ta and Hf, and Te is an arbitrary element).

[FIG. 1]

[FIG. 2]

[FIG. 3]

[FIG. 4]

[FIG. 5]

[FIG. 6]

[FIG. 7]

[FIG. 8]

EXAMPLE 5

SURFACE

THIN FILM
CROSS-SECTION

SUBSTRATE

[FIG. 9]

(a)

EXAMPLE 7

SURFACE

THIN FILM
CROSS-SECTION

SUBSTRATE

(b)

EXAMPLE 25

SURFACE

THIN FILM
CROSS-SECTION

SUBSTRATE

[FIG. 10]

(a) EXAMPLE 7

(b) EXAMPLE 25

[FIG. 11]

(a)

EXAMPLE 7

(b)

EXAMPLE 25

| INTERNATIONAL SEARCH REPORT | International application No. |
| --- | --- |
| | **PCT/JP2022/006864** |

**A. CLASSIFICATION OF SUBJECT MATTER**

*C01B 33/06*(2006.01)i; *H01B 3/12*(2006.01)i; *C30B 29/38*(2006.01)i; *H01L 35/30*(2006.01)i; *H01L 35/32*(2006.01)i
FI:   H01L35/32 A; H01B3/12 309; H01L35/30; C30B29/38 Z; H01B3/12 312; C01B33/06

According to International Patent Classification (IPC) or to both national classification and IPC

**B. FIELDS SEARCHED**

Minimum documentation searched (classification system followed by classification symbols)

C01B33/06; H01B3/12; C30B29/38; H01L35/30; H01L35/32

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2001-071501 A (HEWLETT PACKARD CO.) 21 March 2001 (2001-03-21)<br>    paragraphs [0101]-[0114] | 1-5, 10 |
| Y | | 6-9 |
| Y | MATSUNAGA,Takuya et al. Development of a new heat flow switching device. The 38th International Conference on Thermoelectrics and The 4th Asian Conference on Thermoelectrics, 2019<br>    lines 10-32, fig. 1 | 6, 7 |
| Y | JP 2016-187008 A (SHARP CORP.) 27 October 2016 (2016-10-27)<br>    paragraphs [0037]-[0039], fig. 1 | 7-9 |
| A | JP 10-335710 A (MITSUBISHI MATERIALS CORP.) 18 December 1998 (1998-12-18)<br>    paragraphs [0008], [0009], fig. 1 | 1-10 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **10 May 2022** | **17 May 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/006864**

| Patent document cited in search report | | | Publication date (day/month/year) | Patent family member(s) | Publication date (day/month/year) |
|---|---|---|---|---|---|
| JP | 2001-071501 | A | 21 March 2001 | US 6336713 B1 column 29, line 40 to column 35, line 21 EP 1072418 A2 KR 10-2001-0015482 A | |
| JP | 2016-187008 | A | 27 October 2016 | (Family: none) | |
| JP | 10-335710 | A | 18 December 1998 | (Family: none) | |

Form PCT/ISA/210 (patent family annex) (January 2015)

27

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TAKUYA MATSUNAGA.** Preparation of Heat flow switching Element Operating By Bias Voltage. *15th Academic Lecture of Thermoelectrics Society of Japan,* 13 September 2018